Europäisches Patentamt

European Patent Office

Office européen des brevets

(19)

(11) Veröffentlichungsnummer: **0 002 205**
**B1**

(12) **EUROPÄISCHE PATENTSCHRIFT**

(45) Veröffentlichungstag der Patentschrift: **25.11.81**

(21) Anmeldenummer: **78101376.8**

(22) Anmeldetag: **16.11.78**

(51) Int. Cl.³: **H 01 L 21/302,**
**H 01 L 21/304,**
**H 01 L 21/306,**
**H 01 L 23/36, H 01 L 23/42**

(54) Verfahren zur Erzeugung von Blasensiedezentren auf einer Oberfläche eines Siliciumhalbleiterkörpers, Kühlverfahren unter Verwendung einer derart hergestellten Oberfläche und Anordnung zum Kühlen von Halbleitervorrichtungen.

(30) Priorität: **25.11.77 US 854956**

(43) Veröffentlichungstag der Anmeldung:
**13.06.79 Patentblatt 79/12**

(45) Bekanntmachung des Hinweises auf die Patenterteilung:
**25.11.81 Patentblatt 81/47**

(84) Benannte Vertragsstaaten:
**DE FR GB**

(73) Patentinhaber: **International Business Machines Corporation**
**Armonk, N.Y. 10504 (US)**

(72) Erfinder: **Frieser, Rudolf Gruenspan**
**Clover Hill Road**
**Poughkeepsie New York 12603 (US)**
Erfinder: **Reeber, Morton**
**3508 Frost Road**
**Shrub Oak New York 10588 (US)**

(74) Vertreter: **Kirchhof, Norbert, Ing. grad.**
**Schönaicher Strasse 220**
**D-7030 Böblingen (DE)**

(56) Entgegenhaltungen:
FR - A - 2 143 733
US - A - 2 989 385
US - A - 3 673 017

CHEMICAL ABSTRACTS, Vol. 82, Nr. 24, 16 Juni 1975,
Columbus, Ohio, USA,
Y.A. MIKHAILOV et al. "Etchant", Seite 574

EXTENDED ABSTRACTS OF THE ELECTROCHEMICAL SOCIETY, Vol. 75-2, 5-10. Oktober 1975,
Princeton, USA
M.J. DECLERCO et al. "A comparative study of three anisotropic etchants for silicon", Seiten 446—448, Zusammenfassung Nr. 171

IBM TECHNICAL DISCLOSURE BULLETIN, Vol. 19, Nr. 3, August 1976,
New York, USA
A. HORNUNG et al. "Elimination of super-heating in liquid encapsulated semiconductor modules", Seite 937

IEEE TRANSACTION ON ELECTRON DEVICES, Vol. 23, Nr. 10, Oktober 1976,
New York, USA
F. RESTREPO et al. "On black solar cells or the tetrahedral texturing of a silicon surface", Seiten 1195—1197

EP 0 002 205 B1

**0 002 205**

Verfahren zur Erzeugung von Blasensiedezentren auf einer Oberfläche eines Siliciumhalbleiterkörpers, Kühlverfahren unter Verwendung einer derart hergestellten oberfläche und Anordnung zum Kühlen von Halbleitervorrichtungen

Die Erfindung bezieht sich auf ein Verfahren zur Erzeugung von Blasensiedezentren auf einer Oberfläche eines Siliciumhalbleitkörpers zu seiner Kühlung durch eine halogenierte Kohlenwasserstoffkühlflüssigkeit, bei dem in der Oberfläche eines Siliciumsubstrates durch Sandstrahlen der Oberfläche Gitterdefekte und kristallinische Beschädigungen gebildet werden, auf ein Kühlverfahren unter Verwendung einer derärt hergestellten Oberfläche und auf eine Anordnung zum Kühlen von Halbleitervorrichtungen.

Ein derartiges Verfahren ist aus dem IBM Technical Disclosure Bulletin, Vol. 19, Nr. 3, August 1976, Seite 937 bekannt.

Bei modernen Halbleiterbaueinheiten hoher Packungsdichte ist es erforderlich, Wärme von der Oberfläche erwärmter Halbleiterelemente zu einem Wärmeabzug zu übertragen, mit einer Geschwindigkeit, die ausreicht, um die unvermeidbare Erhöhung der Temperatur des Halbleitermaterials zu begrenzen. Eine derartige Methode zur Wärmeübertragung ist das Eintauchen der Halbleitervorrichtung in eine Kühlflüssigkeit, die sich in einer Kammer befindet, die gewöhnlich mit Kühlrippen ausgerüstet ist. Die in der Halbleitervorrichtung erzeugte Wärme verursacht ein Sieden der Kühlflüssigkeit an der Oberfläche des Halbleiterbauelementes. Die von dem Halbleiterbauelement erzeugte Wärme wird auf die Kühlflüssigkeit übertragen, wenn die Flüssigkeit verdampft. Ein Teil der Wärme wird als latente Wärme bei der Verdampfung der Flüssigkeit absorbiert und die übrige wird durch die Konvektion der Flüssigkeit an der Halbleiteroberfläch absorbiert. Die Bewegung von die Halbleiteroberfläche verlassenden Dampfblasen vernichtet die stagnierende Grenzschicht der Flüssigkeit an der Halbleiteroberfläche, die den Konvektionswärmefluß stark erhöht. Darauffolgend wird der Dampf an den relativ kalten, gerippten Seitenwänden der Kammer, in welcher sich die Flüssigkeit befindet, kondensiert. Typische integrierte Schaltungspackungen sind in den US-PS 3 741 292 und 3 851 221 beschrieben.

Ein bedeutsames Problem bei flüssigkeitsgekühlten Halbleiter-Packungen wird in der Förderung des Blasensiedens gesehen. Die Kühlflüssigkeit muß sehr rein sein, da sie sowohl mit der Metallurgie auf dem die Halbleitervorrichtungen tragenden Substrat als auch mit der Halbleitervorrichtung in Berührung kommt. Irgendein in der Kühlflüssigkeit befindliches Fremdmaterial kann nämlich Verunreinigungsprobleme in der Halbleiterpackung verursachen. Dieses Erfordernis schließt die Anwesenheit von Material in der Kühlflüssigkeit aus, das andernfalls als Zentren zur Förderung des Blasensiedens dienen könnte. Auch die in der Packung montierten Halbleitervorrichtungen haben gewöhnlich nicht die Oberflächenart der Flüssigkeit ausgesetzt, die Blasensieden fördert. Die Siliciumoberfläche ist normalerweise hochpoliert und deshalb frei von Zentren, die das Blasensieden fördern könnten. Ferner benetzen die normalerweise bei solchen Packungen verwendeten Kühlflüssigkeiten, wie Fluorkohlenstoffe, das Silicium, und verhindern deshalb irgendwelche Mängel, die Blasensiedezentren werden könnten, die in anderen Flüssigkeiten derartig wirken könnten. Verschiedene Methoden zur Bildung von Blasensiedezentren auf Siliciumvorrichtungen wurden vorgeschlagen, wie Sandstrahlen oder Ätzen (IBM Technical Disclosure Bulletin Vol 19, Nr. 3, August 1976, Seite 937). Jedoch waren diese Verfahren für Silicium-Fluorkohlenstoff-Systeme nicht zufriedenstellend, da eine unzureichende Anzahl von Zentren des Blasensiedens gebildet wurden. Es wurde auch vorgeschlagen, einen Erhitzer vorzusehen, der aus einem Draht hohen Widerstands, der mit einer geeigneten Stromquelle verbunden ist, besteht, der ein Sieden einleitet und aufrecht erhält. Jedoch war auch dieser Weg nicht zufriedenstellend, da zusätzliche Wärme in die Packung eingeführt wird, was unerwünscht ist, und da das Sieden vorzugsweise auf der Oberfläche der Halbleitervorrichtung erfolgen sollte. Während die zuvor genannten Heizelemente ein augenblickliches Sieden und Zerstören der Packung verhindern, wie z.B. durch eine starke Erhitzung des Kühlmittels, stellt es nicht die Kühlart bereit, die für eine Halbleitervorrichtung hoher Packungsdichte notwendig ist.

Die Erfindung, wie sie in den Ansprüchen gekennzeichnet ist, löst die Aufgabe, ein Verfahren anzugeben für die Erzeugung einer thermisch aktiven Siliciumoberfläche für die Übertragung von Wärme auf eine Siedeflüssigkeit durch Bildung einer ausreichend großen Anzahl von Zentren für das Blasensieden.

Die durch Erfindung erzielten Vorteile sind im wesentlichen darin zu sehen, daß eine Siliciumoberfläche erzeugbar ist, die so komplex ist, daß die Kühlflüssssigkeit die Oberflächenlücken nicht vollständig ausfüllen kann, wodurch Blasensiedezentren entstehen, welche die Kühlwirkung wesentlich verbessern. Es wird somit die Wärmeübertragung zwischen Halbleiterelementen und einer Kühlflüssigkeit verbessert.

Die in den kennzeichnenden Teilen der Ansprüche 3 bis 5 enthaltenen Merkmale sind aus "Extended Abstracts of the Electrochemical Society", Vol. 75-2, Oktober 1975, Seiten 446 bis 448 und die in den kennzeichnenden Teilen der Ansprüche 6 und 7 enthaltenen Merkmale aus der FR - A - 2 143 733 bekannt.

Einzelheiten der Erfindung sind nachstehend anhand von in den Figuren veranschaulichten Ausführungsbeispielen beschrieben. Es zeigen:

Fig. 1 eine flüssigkeitsgekühlte Halbleiterpackung in schaubildlicher Darstellung, bei welcher die Erfindung verwendbar ist;

Fig. 2 ein Flußdiagramm für zwei Schritte des erfindungsgemäßen Verfahrens;

Fig. 3 ein Wärmeflußdiagramm zum Vergleich des erfindungsgemäßen Verfahrens mit konventionellen Verfahren;

Fig. 4 ein Mikrophoto einer mit einem Ätzmittel für Silicium geätzten Siliciumoberfläche;

Fign. 5A und 5B Mikrophotos eines polierten Schrägschliffs und einer Draufsicht auf eine gesandstrahlte Siliciumoberfläche und

Fign. 6A und 6B Mikrophotos eines Schrägschliffs und einer Draufsicht auf eine Siliciumoberfläche, die mit dem erfindungsgemäßen Verfahren hergestellt wurde.

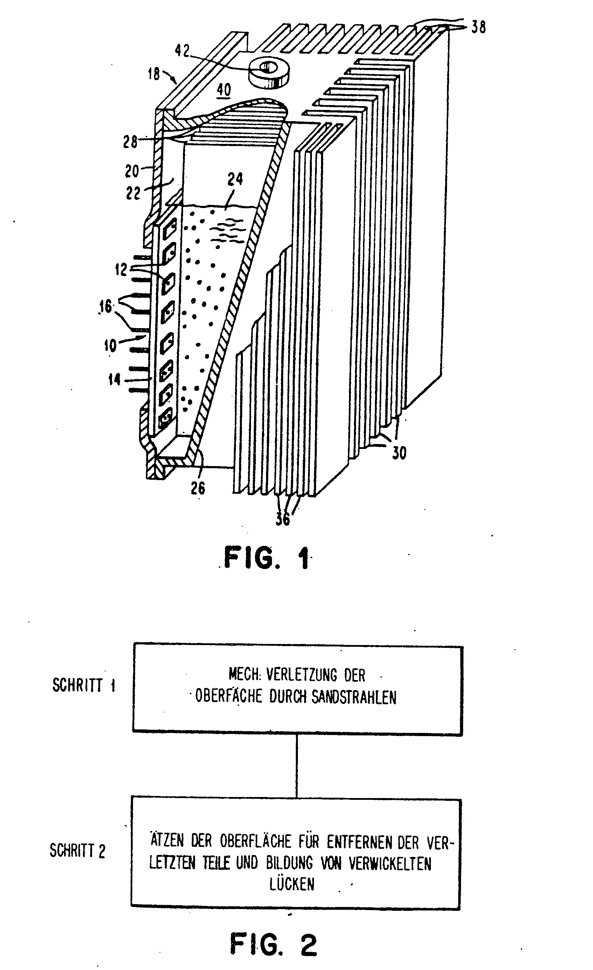

In Fig. 1 ist ein flüssigkeitsgekühltes, elektronisches Modul 10 abgebildet, das mehrere Siliciumchips trägt. Es ist klar, daß der Packungsaufbau von Fig.1 nur zur Erklärung der Erfindung gezeigt ist und in keiner Weise die Erfindung auf das gezeigte Beispiel beschränkt. Das Modul 10 weist eine Anzahl von Chips 12 auf, die auf dem Substrat 14 angeordnet sind. Die Chips 12, von denen ein jedes eine Anzahl von elektronischen Schaltungen enthält, sind entlang einer Fläche auf dem Substrat 14 angeordnet. Die Stifte 16 erstrecken sich weg vom Substrat 14 zum Zwecke des Aufsteckens des Modul 10 auf eine Karte oder andere Tragvorrichtung. Die Chips 12 sind in Reihen auf dem Substrat 14 angeordnet, obwohl diese Anordnung nicht unbedingt erforderlich ist. Der Behälter 18 ist mit dem Substrat 14 des Moduls 10 abgedichtet verbunden. Das Modul 10 bildet somit einen Teil einer Wandung des Behälters 18. Der Flansch 20 erstreckt sich vom Substrat 14 nach oben zur Oberseite des Behälters. Die Länge des Flansches 20 bestimmt die Höhe des Dampfraumes 22 über der Oberseite des Substrates 14.

Der Behälter 18 ist teilweise mit der dielektrischen Flüssigkeit 24 von niedrigem Siedepunkt, wie Fluorkohlenstoff, z.B. FC78 oder FC88, gefüllt. Der Behälter 18 ist damit gefüllt bis auf eine Höhe geringfügig über den Chips 12. Der Bereich über dem Flüssigkeitsspiegel bildet den Dampfraum 22. Die Wandung 26, die der das Modul 10 tragenden Wandung gegenüberliegt, verläuft vom Boden zur Oberseite hin nach außen geneigt. Somit weist der Behälter 18 am Boden einen engen Querschnitt und an seiner Oberseite einen breiten Querschnitt auf. Eine Mehrzahl von Rippen 28 erstreckt sich von der geneigten Wandung 26 in de Behälter 18 hinein. Diese Rippen 28 füllen im wesentlichen den Behälter aus. Die Rippen 28 verlaufen parallel zueinander und erstrecken sich vertikal innerhalb des Behälters. Demzufolge ist der gerippte Oberflächenbereich im Dampfraum 22 wesentlich größer infolge der Neigung der Wandung 26. Es ist ersichtlich, daß die Oberfläche der Rippen 28 abnimmt, da die Rippen sich nach unten im Behälter erstrecken und die Wandung 26 geneigt ist. Die Außenrippen 30 erstrecken sich weg von der Außenseite der geneigten Wandung 26. Die Rippen 36 und 38 befinden sich an den Seitenwänden des Behälters 18, um die Wärme von dem Behälter abzuleiten. Die Deckfläche des Behälters 18 besitzt den Flüssigkeitseinfüllstutzen 42.

Die von den elektronischen Chips 12 erzeugte Wärme verursacht ein Sieden der Kühlflüssigkeit 24 und die Blasen derselben steigen in die dielektrische Flüssigkeit. Der Dampf der Siedeblasen steigt in der Flüssigkeit empor und trit in den Dampfraum 22 aus, wo er an den kühlen Rippen 28 kondensiert. Die Wärme wird durch die Rippen 28 auf die Wandung 26 und die Außenrippen 30 des Behälters 18 übertragen. Die Oberfläche der Rippen 28 im Dampfraum 22 ist groß genug, um der Kondensation des Dampfes eine beträchtliche Fläche zur Verfügung zu stellen.

Die oben genannte Packung wirkt sehr gut, um die durch die in Betrieb befindlichen Chips 12 erzeugte Wärme zu verteilen, vorausgesetzt, daß das Sieden der Flüssigkeit wirksam eingeleitet werden kann. Jedoch ist das Einleiten des Blasensiedens an den Chipoberflächen, welche die heißesten Flächen im System bilden, nicht immer zuverlässig wegen der notwendigen Reinheit der Kühlflüssigkeit, der polierten Oberfläche der Rückseite der Chips und der Wahl der Flüssigkeit für elektronische Systeme, die Siliciumflächen sehr benetzen. Die Einleitung des Siedens an einer erhitzten, festen Oberfläche, die in eine Flüssigkeit eingetaucht ist, geschieht und diskreten Stellen, den sogenannten Blasensiedestellen. Diese Stellen sind örtliche Ungleichförmigkeiten, die mit der Flüssigkeit nicht ausgefüllt sind und eine kleine Dampfflüssigkeitgrenzschicht hinterlassen. Die von der festen Oberfläche erzeugte Wärme kann direkt zu einem Verdampfen der Flüssigkeit führen, wobei an dieser Stelle eine Blase wächst. Bei Nichtvorhandensein dieser Grenzschicht muß genügend Energie zur Verfügung stehen, um die Grenzschicht vor dem Wachsen der Blase errichten zu können. Dies erfordert eine grobe örtliche Energieschwankung oder ein Ansteigen der Temperatur. Wenn eine Oberfläche mit einer Flüssigkeit gut benetzt ist, wie es im Falle von einer Fluorkohlenstoffflussigkeit und einer Siliciumoberfläche der Fall ist, sind diese örtlichen Oberflächenunregelmäßigkeiten vollständig mit Flüssigkeit ausgefüllt und es tritt kein Blasenseiden ohne beträchtlichen Temperaturanstieg ein. Es wird die Theorie aufgestellt, daß Blasensiedestellen garantiert werden können, wenn eine oberfläche erzeugt wird, die so komplex ist, daß die Flüssigkeit die Lücken nicht vollständig ausfüllen kann.

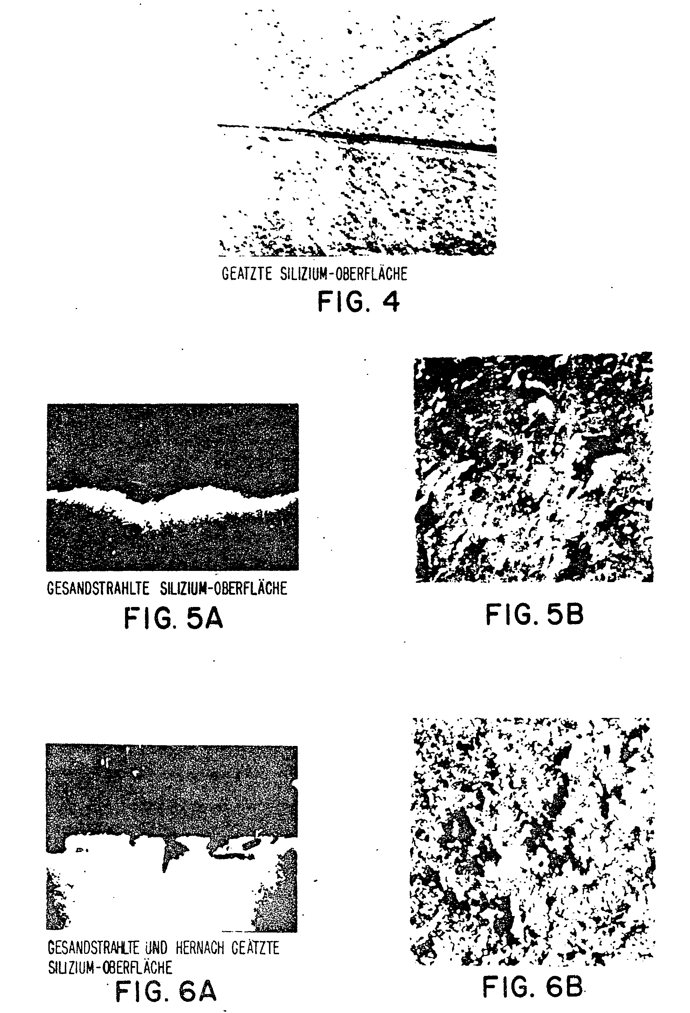

Schritt 1 (Fig. 2) beinhaltet das mechanische Beschädigen oder Verletzen der Oberfläche eines Siliciumchips, um kleine Gitterdefekte herzustellen. Die letzteren können durch Sandstrahlen der Rückseite des Siliciumchips erzeugt werden. Ein bevorzugtes Ausführungsbeispiel sieht das Sandstrahlen mit einem Dampfsandstrahler vor für die Zeitdauer von 1 bis 2 Minuten mit einem Gesamtdruck von 34,2 kg. Ein bevorzugtes Abriebmittel ist ein wässriger Schlamm von Aluminiumoxid oder Kieselerde mit einer Teilchengröße, die sich durch Verwendung eines Siebes mit einer Maschenweite von 0,38 mm ergibt. Bevor die Waferplättchen (kurz Plättchen genannt) in einzelne Vorrichtungen unterteilt werden, können sie entweder mit der Hand gehalten werden oder können auf eine Kunststoff- oder Glasscheibe mit Glykolphthalat geklebt sein. Meistens sind zwei Minuten ausreichend, um über die gesamte Plättchenoberfläche ein gleichförmige Stumpfheit zu erzeugen. Das sandgestrahlte Plättchen wird dan in fließendem entionsiertem wasser (D.I.-Wasser) gewaschen und in einem Stickstoffstrom getrocknet. Die mittels des Sandstrahlens erzielte Oberflächenrauheit ist aus den Figuren 5A und 5B ersichtlich. In Fig. 5A ist ein 1,5° polierter Schrägschliff bei 2500facher Vergrößerung dargestellt. In Fig. 5B ist eine Interferenzkontrast-Auflichtmikrophotographie bei 1600facher Vergrößerung gezeigt. Es ist zu bemerken, daß, obwohl die Oberfläche aufgerauht ist, das Sandstrahlen allein die komplizierten Lücken nicht erzeugen konnte.

Den zweiten Schritt des erfindungsgemäßen Verfahrens bildet ein Ätzen der Oberfläche des sandgestrahlten Plättchens, um die beschädigten Stellen zu entfernen und um komplizierte Lücken bzw. Fugen zu bilden, die als Blasensiedezentren wirken. Für das genannte Entfernen der beschädigten Stellen ist irgendein geeignetes Siliciumätzmittel verwendbar. Ein bevorzugtes Siliciumätzmittel ist ein Brenzcatechin-Amin-Wasser, das aus 16 ml entionisiertem Wasser (D.I.-Wasser), 34 ml Äthylendiamin und 6 g Brenzcatechin zusammengesetzt ist. Ein anderes bevorzugtes Siliciumätzmittel ist eine wässerige Kaliumhydroxidlösung, im besonderen eine 1/4 5n KOH, 3/4 Wasserlösung. Das Ätzen kann bei irgendeiner geeigneten Temperatur, vorzugsweise zwischen 50 und 80°, erfolgen. Die Ätzzeit liegt in der Größenordnung von 1 bis 2 Minuten. Das Atzen der Siliciumoberfläche, in welche durch das Sandstrahlen Gitterdefekte eingeführt wurden, erzeugt eine sehr komplexe Oberfläche, wie aus den Figuren 6A und 6B ersichtlich ist. Fig. 6A stellt einen polierten 1,5° Schrägschliff bei 2220facher Vergrößerung dar. Fig. 6B ist eine Interferenzkontrast-Auflichtmikrophotographie von 1600facher Vergrößerung. Die Oberfläche ist sehr unregelmäßig und weist komplizierte Lücken auf, die nachweisbar als effektive Blasenzentren wirken. Der Wirkungsgrad der Kombination aus Ätzen und Sandstrahlen im Vergleich zu alleinigem Sandstrahlen zum Erzeugen der komplizierten Lücken ist beurteilbar durch Vergleich der Figuren 5A und 5B mit den Figuren 6A und 6B. Röntgenaufnahmen zeigen, daß das im Schritt 1 beschriebene Sandstrahlen große Spannungen in das Plättchen einführt. Nach Beendigung des Ätzvorganges sind die Spannungen größtenteils abgefallen.

Die folgenden Beispiele 1 bis 3 betreffen die Herstellung von Vergleichsobjekten, welche die besonders günstige Kühlwirkung des im folgenden Beispiel 4 behandelten Erfindungsgegenstandes demonstrieren.

## Beispiel 1

Das thermische Verhalten einer polierten Siliciumoberfläche wurde geprüft. Ein erstes poliertes Plättchen wurde auf einen Halter aus Phenolharz befestigt, in dem eine Wärmequelle eingebettet war in unmittelbarer Nähe der Rückseite des Plättchens und ebenfalls ein thermoelektrisches Element.

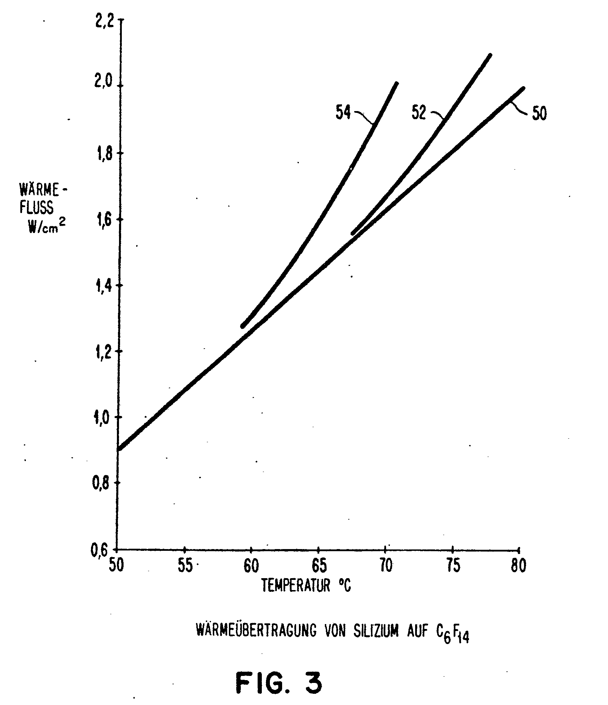

Die Wärmequelle war eine Kupferspule von 25mm Durchmesser und 6 mm Dicke, gewunden aus einem 0.08 mm (40 Gauge) dicken Kupfernickeldraht. Das thermoelektrische Element war im Zentrum der Kupferspule angeordnet. Das Plättchen mit einem Durchmesser von 60 mm war so angeordnet, daß die ausgesetzte Fläche im wesentlichen mit dem Halter bündig war und mit der Rückseite in Berührung mit der Wärmequelle stand. Diese Anordnung wurde dann in eine Zelle gebracht, die mit Perfluorhexan auf eine Tiefe von 1,7 cm über der Oberseite des montierten Plättchens gefühlt war. Auf der gleichen Tiefe wie das Zentrum des Plättchens war ein Quecksilberthermometer permanent angeordnet, um die Flüssigkeitstemperatur zu messen. In dem Abdichtdeckel des Behälters war ein Gegenstromkondensator befestigt, um Flüssigkeitsverluste zu vermeiden. Alle Messungen während des Tests wurden in einem quasi statischen Zustand vorgenommen, nachdem der Strom für mindestens 30 Minuten aufrechterhalten wurde. Die gemessenen Werte waren die Wärmequellentemperatur, der Wärmequellenstrom, die verstrichene Zeit und die Grundflüssigkeitstemperatur. Vor Abnahme irgendwelcher Daten wurde die Oberfläche des Plättchens durch Sieden während 12 Stunden und Abkühlen auf Raumtemperatur während vier Stunden entgast. Verschiedene Stromeingänge zur Wärmequelle wurden gemacht und die Temperatur des Plättchens wurde gemessen, nachdem das System einen stabilen Zustand erreicht hatte. Die so entnommenen Daten wurden aufgezeichnet und sind in Fig. 3 als Kurve 50 dargestellt. Es ist zu bemerken, daß die Kurve 50 über dem gesamten Temperaturbereich im wesentlichen gerade verläuft, was anzeigt, daß die Wärme von dem polierten und unbehandelten Plättchen auf die Flüssigkeit primär durch Leitung übertragen wurde.

## Beispiel 2

Die Oberfläche eines zweiten Siliciumplättchens wurde für eine Minute mit einem Kaliumhydroxidätzmittel aus einer 5 n Lösung von KOH in Wasser verdünnt mit ungefähr drei Teilen Wasser zu einem Teil KOH-Lösung geätzt. Die Temperatur, bei welcher das Ätzen stattfand, betrug 50°C. Dem Ätzen folgte ein Uberprüfen der Oberfläche, wobei viele Löcher von der Form vierseitiger Pyramiden gefunden wurden. Die Art der sich dabei ergebenden geätzten Oberfläche ist in Fig. 4 dargestellt, die eine Interferenzkontrast-Auflichtmikrophotographie bei 1600facher Vergrößberung darstellt. Das Plättchen wurde hierauf auf dem im Beispiel 1 beschriebenen Halter angeordnet und dieselben Messungen durchgeführt. Die erhaltenen Daten wurden in Fig. 3 eingezeichnet, und die sich ergebende Kurve wurde als übereinstimmend mit der Kurve 50 gefunden. Dies zeigt an, daß keine wesentliche Verbes-

4

serung des Blasensiedens durch das Ätzen einer polierten Siliciumoberfläche erhalten wurde.

## Beispiel 3

Ein drittes Siliciumplättchen wurde, wie in Verbindung mit Schritt 1 beschrieben, gesandstrahlt und wurde dann auf dem im Beispiel 1 beschriebenen Phenolharzhalter angeordnet. Dieselbe Art von Versuchen wurde gemacht, um die Blasensiedecharakteristik zu beurteilen. Die such ergebenden Daten wurden in Fig. 3 aufgezeichnet und erscheinen als Kurve 52. Diese Kurve zeigt an, daß einige Verbesserungen der Blasensiedecharakteristik einer Siliciumoberfläche durch Sandstrahlen der Oberfläche erzielt wurden im Vergleich zu einer polierten Siliciumoberfläche oder einer polierten und geätzten Siliciumoberfläche.

## Beispiel 4

Ein viertes Siliciumplättchen wurde ausgewählt und dem Sandstrahlen eine Minute lang ausgesetzt. Dies wurde in einem Dampfsandstrahler getan, der eine Standard-, mehrfach perforierte Düse in einer Entfernung von 15 bis 20 cm vom Substrat aufwies und bei einem Gesamtdruck von 34,2 kg arbeitete. Das Abriebmittel war ein Wasserschlamm aus Aluminiumoxid mit einer Teilchengröße, die sich durch Verwendung eines Siebes mit einer Maschenweite von 0,38 mm ergab. Nach zwei Minuten Sandstrahlen war eine gleichförmige Stumpfheit auf der gesamten Oberfläche des Plättchens erzeugt. Das Plättchen wurde dann in einem fließenden entionisierten Wasser (D.I.-Wasser) gewaschen und in einem Stickstoffstrom getrocknet. Darauffolgend wurde das Plättchen mit einem Kaliumhydroxidätzmittel geätzt, das aus einer 5n Lösung von KOH verdünnt in Wasser mit drei Teilen Wasser auf ein Teil Lösung bestand. Das Substrat wurde dann dem Ätzmittel für ungefähr 1 1/2 Minuten bei 80°C ausgesetzt. Das sich daraus ergebende sandgestrahlte und geätzte Plättchen wurde dann in dem Phenolharzhalter angebracht und seine Siedecharakteristik wie im Beispiel 1 bestimmt. Die Daten wurden dann in Fig. 3 eingezeichnet, in welcher sie als Kurve 54 erscheinen. Die Kurve 54 zeigt an, daß die behauptete Verbesserung durch Verwendung der Kombination aus Sandstrahlen und Ätzen erzielt wurde. Die Verbesserung beträgt klar mehr als die additiven Einflüsse des Ätzens und Sandstrahlens, wie durch die Kurven 50 und 52 gezeigt ist.

## Patentansprüche

1. Verfahren zur Erzeugung von Blasensiedezentren auf einer Oberfläche eines Siliciumhalbleiterkörpers zu seiner Kühlung durch eine halogenierte Köhlenwasserstoffkühlflüssigkeit bei dem in der Oberfläche eines Siliciumsubstrates durch Sandstrahlen der Oberfläche Gitterdefekte und kristalline Beschädigungen gebildet werden, dadurch gekennzeichnet, daß die Gitterdefekte und kristallinischen Beschädigungen durch ausgewähltes Aussetzen dieser Oberfläche einem Ätzmittel für Silicium entfernt werden.

2. Verfahren nach Anspruch 1, dadurch gekennzeichnet, daß das Sandstrahlen der Siliciumoberfläche mit einem Wasserschlamm aus Aluminiumoxidgries mit einer Teilchengröße, die sich durch Verwendung eines Siebes mit einer Maschenweite von 0,38 mm ergibt, erfolgt.

3. Verfahren nach Anspruch 2, dadurch gekennzeichnet, daß die Siliciumoberfläche in einer KOH-Lösung geätzt wird.

4. Verfahren nach Anspruch 2, dadurch gekennzeichnet, daß die Siliciumoberfläche mit einem Äthylen-Wasser-Brenzcatechin-Ätzmittel geätzt wird.

5. Verfahren nach Anspruch 4, dadurch gekennzeichnet, daß die Temperatur des Ätzmittels während des Ätzvorganges etwa 50 bis 80°C beträgt.

6. Kühlverfahren für integrierte Siliciumhalbleiterschaltungen, deren Siliciumoberflächen nach dem Verfahren nach Anspruch 1 behandelt sind, dadurch gekennzeichnet, daß mittels einer Fluorkohlenstoffkühlflüssigkeit gekühlt wird.

7. Kühlvorrichtung zur Ausführung des Kühlens nach Anspruch 6, dadurch gekennzeichnet, daß die zu kühlenden Halbleiterschaltungschips (12) auf einem Substrat (14) angeordnet sind, das einen Teil einer Wandung eines Behälters (18) bildet, dessen dem Substrat (14) gegenüberliegende Wandung (26) von unten gesehen schräg nach außen verläuft und daß von dieser Wandung (26) sich in den Behälterinnenraum parallel zueinander verlaufende Kühlrippen (28) erstrecken, daß der Behälter (18) bis über das oberste Chip (12) hinaus mit der Kühlflüssigkeit (24) gefüllt ist und daß über dem Kühlflüssigkeitsspiegel ein freier Raum (22) zur Dampfbildung bestehen bleibt, in den die genannten Kühlrippen (28) ragen.

8. Vorrichtung nach Anspruch 7, dadurch gekennzeichnet, daß der Behälter (18) auch an seinen Außenseiten Kühlrippen (36, 38) aufweist.

## Claims

1. A method of producing nucleate boiling sites on a surface of a silicon semiconductor body for cooling said body by means of a halogenated hydrocarbon cooling fluid, wherein by means of sandblasting the surface of a silicon substrate lattice defects and crystalline damage are made in said surface, characterised in that the lattice defects and crystalline damages are removed by selectively exposing this surface to a silicon etchant.

2. A method as claimed in claim 1, characterised in that the sandblasting of the silicon surface is effected with a water slurry of alumina oxide grit with a particle size obtained through using a sieve with a mesh width of 0.38 mm.

3. A method as claimed in claim 2, characterised in that the silicon surface is etched in a KOH solution.

4. A method as claimed in claim 2, characterised in that the silicon surface is etched with an ethylene-water-pyrocatechol etchant.

5. A method as claimed in claim 4, characterised in that the temperature of the etchant is approximately 50 to 80°C during etching.

6. A cooling method for integrated silicon semiconductor circuits having their silicon surfaces processed in accordance with the method of claim 1, characterised in that cooling is effected by means of a fluorocarbon liquid coolant.

7. Device for carrying out cooling in accordance with claim 6, characterised in that the semiconductor chips (12) to be cooled are arranged on a substrate (14) forming part of a wall of a container (18) whose wall (26) facing the substrate (14) slopes outward seen from below, and in that from this wall (26) there extend parallel cooling fins (28) protruding into the container interior, in that the container (18) is filled over the top chip (12) with the cooling liquid (24), and in that there remains over the cooling liquid level a free space (22) for vapour generation into which protrude the above cooling fins (28).

8. Device as claimed in claim 7, characterised in that the container (18) shows cooling fins (36, 38) also at its outer walls.

## Revendications

1. Procédé pour former des emplacements de nucléation de bulles sur une surface d'un corps semi-conducteur de silicium pour le refroidissement de celui-ci par un liquide de refroidissement d'hydrocarbure halogéné, dans lequel on réalise, à la surface d'un substrat de silicium, des défauts de réseau et des endommagements cristallins en soumettant cette surface à un jet de sable, caractérisé en ce que les défauts de réseau et les endommagements cristallins sont enlevés en soumettant cette surface sélectivement à un décapant pour le silicium.

2. Procédé selon la revendication 1 caractérisé en ce que le traitement de la surface de silicium par jet de sable utilise une pâte aqueuse de granulés d'oxyde de silicium, la dimension des particules étant déterminée par l'utilisation d'un tamis d'un diamètre de maille de 0,38 mm.

3. Procédé selon la revendication 2, caractérisé en ce que la surface du silicium est décapée à l'aide d'une solution de KOH.

4. Procédé selon la revendication 2, caractérisé en ce que la surface du silicium est décapée à l'aide d'un décapant d'éthylène-eau-pyrocatéchine.

5. Procédé selon la revendication 4, caractérisé en ce que la température du décapant durant le processus de décapage est comprise entre environ 50 et 80°C.

6. Procédé de refroidissement pour des circuits semi-conducteurs intégrés de silicium dont les surfaces de silicium sont traitées selon le procédé de la revendication 1, caractérisé en ce que le refroidissement utilise un liquide de refroidissement au fluorocarbone.

7. Dispositif de refroidissement pour procéder à un refroidissement selon la revendication 6, caractérisé en ce que les microplaquettes semi-conductrices à refroidir (12) sont disposées sur un substrat (14) formant une partie d'une paroi d'un récipient (18) dont la paroi (26) faisant face au substrat (14) s'évase vers l'extérieur, vu du dessous, et en ce que des barres de refroidissement (18) disposées en parallèle s'étendent, à partir de cette paroi (26), vers l'intérieur du récipient, en ce que le récipient (18) est rempli d'un liquide de refroidissement (24) couvrant la microplaquette la plus haute, et en ce que, pour la formation de la vapeur, il reste un espace libre (22) dans lequel pénètrent lesdites barres de refroidissement (28).

8. Dispositif selon la revendication 7, caractérisé en ce que même les parois extérieures du récipient (18) sont munies de barres de refroidissement (36, 38).

**FIG. 1**

| | |
|---|---|
| SCHRITT 1 | MECH. VERLETZUNG DER OBERFÄCHE DURCH SANDSTRAHLEN |
| SCHRITT 2 | ÄTZEN DER OBERFLÄCHE FÜR ENTFERNEN DER VER-LETZTEN TEILE UND BILDUNG VON VERWICKELTEN LÜCKEN |

**FIG. 2**

WÄRMEÜBERTRAGUNG VON SILIZIUM AUF $C_6F_{14}$

FIG. 3

GEÄTZTE SILIZIUM-OBERFLÄCHE

FIG. 4

GESANDSTRAHLTE SILIZIUM-OBERFLÄCHE

FIG. 5A

FIG. 5B

GESANDSTRAHLTE UND HERNACH GEÄTZTE
SILIZIUM-OBERFLÄCHE

FIG. 6A

FIG. 6B

3